# EUROPEAN PATENT SPECIFICATION

(11) **EP 0 760 191 B1**
(45) Date of publication and mention of the grant of the patent: **23.06.1999**
(21) Application number: 95919871.4
(22) Date of filing: 18.05.1995
(51) Int. Cl.: H04N 3/15

(54) **CMOS IMAGING ARRAY WITH ACTIVE PIXELS**
CMOS-BILDMATRIX MIT AKTIVEN BILDELEMENTEN
GRILLE D'IMAGERIE CMOS A PIXELS ACTIFS

(30) Priority: 19.05.1994 US 246341
(43) Date of publication of application: 05.03.1997
(73) Proprietor: POLAROID CORPORATION, Cambridge, Massachusetts 02139-3589 (US)
(72) Inventor: HSIEH, Tzu-Chiang, Newton, MA 02159 (US); McGRATH, R., Daniel, Andover, MA 01840 (US)
(74) Representative: Koch, Günther, Dipl.-Ing.
(86) International application number: US9506214
(87) International publication number: WO9532580

(56) References cited:
- EP-A- 0 046 396
- EP-A- 0 195 525
- EP-A- 0 367 650
- US-A- 4 620 232
- SENSORS AND ACTUATORS A, vol. a44, no. 1, July 1994 LAUSANNE CH, pages 29-35, XP 000469151 N. RICQUIER ET AL. 'Random addressable CMOS image sensor for industrial applications'

## Description

The invention relates to an image sensing device and an image sensing array in accordance with the preamble of claims 1 and 11 respectively. The invention further relates to a method for converting optical radiation into an electrical signal as defined in the preamble of claim 23.

### BACKGROUND OF THE INVENTION

Image sensing devices which operate by performing the steps of sensing incident optical radiation, converting the radiation into charge carriers, and storing the charge carriers in photosensitive material are well known in the art. The output signal of the image sensing device, or pixel, originates with a transmittal of the stored charge carriers. The charge is transmitted from the pixel to processing electronics or storage media, usually by a series of bucket-brigade registers or a sequence of charge-coupled devices (CCDs). During transmission, the output signal is very susceptible to the acquisition of noise because the signal consists of charge carriers. Recent work in the relevant art has addressed noise susceptibility problems, and has also sought to lower the cost of CCD-based imagers.

Noise appearing on the output signal is acquired in a number of different ways, including: excess charge generation, thermal activity in the circuit, charge carrier losses, variation among pixels, and irregularity in resetting operations. One design approach to solving this problem incorporated a photodiode, a FET switch, and a charge-domain readout in the pixel. Although this did result in some commercial success, the problems related to these sources of noise have not been satisfactorily overcome.

Fabricating a CCD-based imager is relatively costly because of the number of specialized manufacturing operations performed. Reducing the physical size of an imaging pixel reduces its fabrication costs as well. But this also reduces the dynamic range of the image-sensing pixel. As the pixel size is decreased the noise level decreases, but the signal strength decreases at a faster rate than does the noise level. In turn, a reduced dynamic range places greater design requirements on the imaging system optics.

Notwithstanding the above design problems, the prevalent image acquisition technology is largely based on sensing devices utilizing CCDs for optical radiation detection. Such devices are used in various commercial image acquisition products such as camcorders and still video cameras, both of which are directed to a vast consumer market. However, when the operational characteristics and the fabrication of CCD-based electronics are considered, additional difficulties become apparent.

The operation of circuits incorporating CCDs, for example, requires that nonstandard voltages be supplied to the CCDs. This, in turn, requires a more complex power supply and distribution circuitry within the processing electronics. These requirements make more difficult the task of integrating circuits employing CCDs into an electronic system which otherwise would use only standard voltages. The need for nonstandard voltages also increases the complexity of the fabrication process.

This increased complexity of CCD-based electronics necessitates specialized manufacturing operations which usually add to the cost of producing such imagers. In contrast, solid-state devices manufactured using high-volume techniques, such as memories, logic chips, and analog processing components, are fabricated without need for the specialized manufacturing operations required for CCD-based devices. Clearly, if high-volume production techniques could be used for image sensing devices without the need for specialized operations, the cost of solid-state sensors could be reduced. To date, this has not been realized and the costly CCD-based technology remains predominant.

What is needed is a light sensing device which would make use of standard, high-volume manufacturing techniques and which would incorporate a circuit design less susceptible to the noise-producing processes encountered in the relevant art. Preferably, such a device would incorporate circuit architecture not utilizing CCDs, and having easily-integratable components readily fabricated by utilizing low cost, commercially-available manufacturing technology.

EP-A-0046396 discloses an image sensing device in accordance with the preamble of claims 1 and 11 having a plurality of picture elements in a two dimensional array. Each element has a photoelectric conversion element and a switching field effect transistor to permit scanning of the elements by scanners. To counteract noise and blooming, a second transistor acts as an amplifier between the photoelectric conversion element and the transistor, and a third transistor acts to reset the photoelectric elements. There is a reference voltage source comprising a charged capacitor which serves as an exponentially-decreasing source, in the process of discharging. As disclosed a power supply voltage is supplied from an output terminal through a load resistor. That power supply voltage is once stored in the capacitor of a vertical signal line simultaneously with the reading operation and is released by the amplifying transistor when the switching transistor is rendered conductive.

It is an object of the invention to provide an imaging device in which the level of noise appearing on a signal output line is held to a minimum and to provide an imaging device with an increased image-sensing dynamic range.

It is a further object of the invention to provide an imaging device which provides signal information in a mode different from the charge-collection mode of image detection.

It is a further object of the invention to provide an imaging array which can be fabricated on a single substrate thereby minimizing the required number of processing operations.

It is a further object of the invention to provide an imaging array which is comprised of components which require only standard voltages for operation.

It is a further object of the invention to provide a method for converting optical radiation into an electrical signal corresponding to the amount of radiation resulting in the above criterions.

The above objects are achieved by the characterizing clause of claims 1 and 11 as far as the image sensing device and image sensing array respectively are concerned and by the characterizing clause of claim 23 as far as the method for converting optical radiation into an electrical signal is concerned.

The invention therefore comprises an image sensing device in which the image-detection circuit is electrically isolated from the signal-sensing circuit Charge carriers, generated by a photo-sensitive component receiving optical radiation, are collected to produce an electric field within the sensing device. The electric field is used to modify the electrical resistance of a resistive component, one end of which is held at a fixed voltage by a first voltage source. This voltage source produces an electrical signal output corresponding to the amount of radiation received by the photo-sensitive component. With this configuration, the charge-collection circuit is decoupled from the signal-sensing circuit. The voltage source also serves to maintain a signal line at an essentially constant potential. The electrical signal output may be further converted to a voltage signal by means of a current-to-voltage convertor. Additionally, the pixel may be initialized by means of a reset feature which makes use of a second voltage source to place the photosensitive element into a depleted state.

In another embodiment, multiple image sensing devices are arranged in an array, comprised of rows and columns of pixels, the output electrical signals of which are sequentially routed to one or more convertors by means of row and column selectors. The selectors may be either sequential and comprised of flip-flops, or they may be multiplexing and incorporate signal decoders and transmission gates. Alternatively, the output pixel signals may be converted to voltage signals prior to passing through a column selector. The invention also features a method of using a single power source to supply electrical power to more than one current-to-voltage convertor.

CMOS technology can be used to implement the design features of the inventive device. By means of an integrated process, the fabrication of active components, whether p-MOS or n-MOS, can be accomplished on the same substrate. This serves to minimize the number of processing operations required for device fabrication.

### BRIEF DESCRIPTION OF THE DRAWINGS

The novel features that are considered characteristic of the present invention are set forth with particularity herein. The organization and method of operation of the invention, together with other object and advantages thereof, will be best understood from the following description of the illustrated embodiments when read in conjunction with the accompanying drawings wherein:
Fig. 1 is a schematic of an image sensing device according to the present invention;
Fig. 2 is a schematic of an alternate embodiment of the pixel included within the image sensing device of Fig. 1;
Fig. 3 is a block diagram of an image sensing array according to the present invention in which signals are serially outputted by a current-to-voltage convertor;
Fig. 4 is a block diagram of an alternate to the embodiment of the image sensing array of Fig. 3 in which signals are outputted in parallel by two current-to-voltage convertors;
Fig. 5 is a block diagram of an alternate to the embodiment of the image sensing array of Fig. 3 in which signals are converted to voltage signals prior to being outputted by a column multiplexer;
Fig. 6 is a schematic of a flip-flop as used in one embodiment of a row scanner in the block diagram of Fig. 3; and,
Fig. 7 is a schematic of a pair of transmission gates as used in one embodiment of a column multiplexer in the block diagram of Fig. 3.

### DETAILED DESCRIPTION OF THE INVENTION

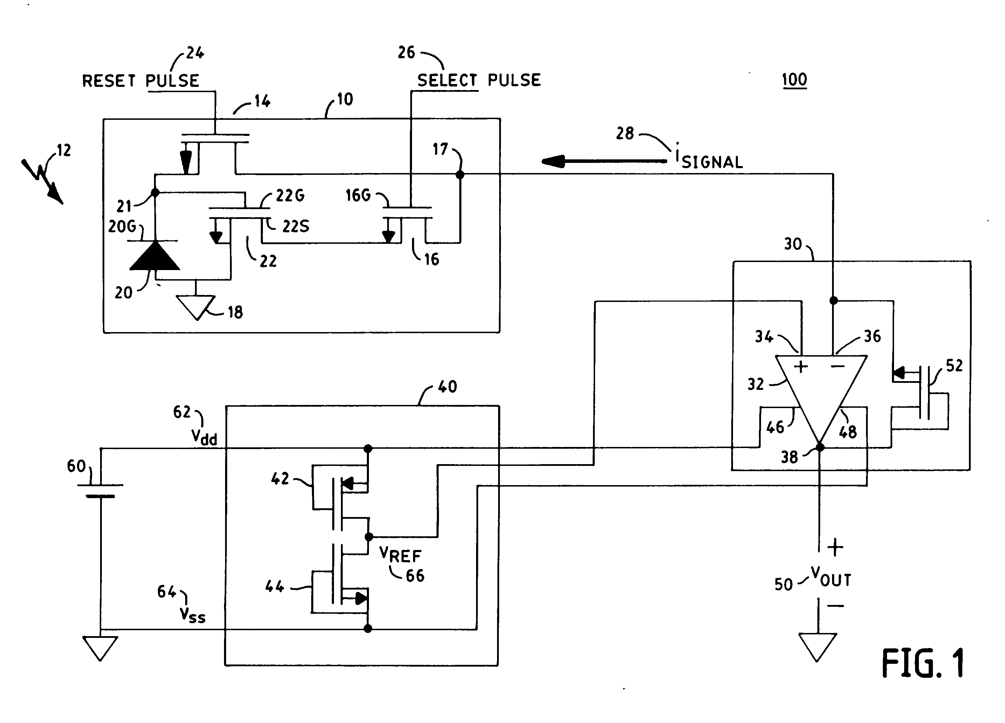

Referring now to Fig. 1, there is shown a schematic of one embodiment of the present invention. Optical radiation 12, which may, for example, correspond to a portion of an image being sensed, is incident upon an image sensing device 100. Image sensing device 100 includes a pixel 10 for receiving the optical radiation 12 and produces a current signal 28 having an amplitude which is proportional to the amount of optical radiation 12 acquired. Current signal 28 is converted into a voltage signal 50 by means of a convertor 30. Electrical power for operation of both pixel 10 and convertor 30 is provided by means of a bias source 40.

### Operation of an Image Sensing Device

Optical radiation 12 received by pixel 10 strikes a suitably-biased photodiode 20, or other photosensitive device, which generates charge carrier pairs in response to incident radiation. The number of charge carrier pairs generated by photodiode 20 is proportional to the amount of optical radiation 12 acquired. As charge carrier pairs are generated, charge carriers of one polarity flow to a pixel ground 18, and charge carriers of the opposite polarity flow to a charge carrier accumulating component. The accumulating component collects these charge carriers and produces an electrical field having a magnitude proportional to the total number of charge carriers accumulated. In the embodiment shown, an n-MOSFET serves as a FET accumulator 22. Positively-charged carriers (*i.e*., "holes") flow to pixel ground 18, and negatively-charged carriers *(i.e.,* electrons) collect at a gate terminal 22g of FET accumulator 22 while charge carrier pairs are being generated by photodiode 20. This action produces an electrical field in the FET channel. In an alternative configuration (not shown), a p-MOSFET serves as a FET accumulator, the photodiode 20 is reversed from the orientation shown, the photodiode biasing voltage is reversed in polarity, and the charge carrier flows are correspondingly interchanged.

The electrical field produced by FET accumulator 22 causes a variation in the FET channel resistance. The degree to which the channel resistance varies depends upon the amount of optical radiation 12 incident on photodiode 20. This change in channel resistance, which is proportional to the amount of charge carrier pairs generated by photodiode 20, provides a measurement parameter by which the amount of radiation received by pixel 10 can be quantitatively determined over a relatively large range of illumination. In a physical embodiment, FET channel resistance, measuring less than 20K ohms with no charge present at the FET gate terminal, can increase to over 10M ohms when charge accumulation is at a maximum.

FET channel resistance is measured by applying a reference voltage 66 (V_{REF}) to the source terminal 22s of FET accumulator 22 and measuring the resulting current signal 28. Reference voltage 66 is obtained from bias source 40. In the embodiment shown, reference voltage 66 is applied to FET accumulator source terminal 22s by closing a FET select switch 16 when the resistance is to be determined. Select switch 16 is closed by applying a select pulse 26 along a select-pulse line to the select switch gate terminal 16g. When select switch 16 closes, this action completes an electrical circuit between bias source 40 and source terminal 22s of FET accumulator 22. Reference voltage 66 is present at the positive input port 34 of an operational amplifier 32 in convertor 30, and also appears at negative input port 36. With the closing of select switch 16, reference voltage 66 is applied to FET accumulator source terminal 22s. In one embodiment, the select pulse consisted of a five-volt pulse applied for approximately one µsec to the gate terminal of a FET select switch (not shown).

Current signal 28, produced by placing source terminal 22s at the potential of reference voltage 66, flows along a signal-sensing line lying between a signal sensing node 17 and pixel ground 18. During operation of pixel 10, noise produced by internal current fluctuations is present on a photocharge-integration line lying between a photocharge integration node 21 and FET accumulator gate 22g. The noise on this photocharge-integration line appears as voltage fluctuations on the signal-sensing line by means of capacitive coupling across the channel of FET accumulator 22. However, these voltage fluctuations are suppressed in the inventive device because the signal-sensing line is held at an essentially constant potential, corresponding to the reference voltage 66 potential applied to source terminal 22s of FET accumulator 22.

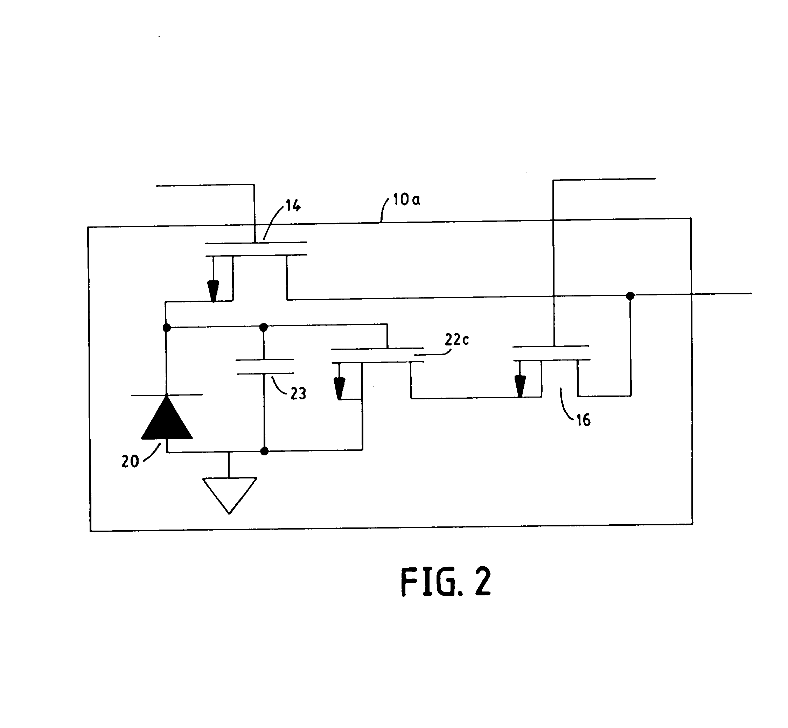

In an alternative embodiment, pixel 10a is comprised of photodiode 20, reset switch 14, and select switch 16 as shown in Fig. 2. An accumulator capacitor 23 is used for the collection of charge carriers and production of an electrical field. The electrical field produced by accumulator capacitor 23 causes a variation in the resistance of a FET channel 22c. The resistance of FET channel 22c is determined by applying reference voltage 66 to the FET source terminal and measuring the resultant current signal, using the same method as described for pixel 10 above.

As shown in Fig. 1, electrical power is provided to bias source 40 by means of a power source 60 which supplies both a floating bias voltage 62 (v_{dd}) and a floating low voltage 64 (Vₛₛ) to bias source 40. Bias source 40 converts the bias voltage 62 and the low voltage 64 into reference voltage 66 by means of a suitable dc-to-dc convertor circuit. The convertor may consist of a bias-voltage FET 42 and a low-voltage FET 44 as shown. In a preferred embodiment, bias voltage V_{dd} is about +5.0 volts, low voltage Vₛₛ is about 0.0 volts, and reference voltage V_{REF} is about 2.5 volts. With a reference voltage of 2.5 volts applied to the source terminal of an n-MOS device, the current signal observed can vary from less than one to over 100 µamp, which results in a correspondingly large dynamic range for image sensing device 100.

Reference voltage 66 is also the voltage source by which photodiode 20 is initialized, or placed into a depleted state, when a reset switch 14 is closed. Additionally, the application of reference voltage 66 in biasing photodiode 20 acts to initialize pixel 10 by draining charge carriers from FET accumulator 22 to pixel ground 18, thus setting the amount of charge carriers present at gate terminal 22g. A reset pulse 24 is applied along a reset-pulse line to close reset switch 14, here shown as a FET switch, and complete an electrical path between convertor 30 and pixel ground 18 through photocharge integration node 21. Reset pulse 24 has a time-voltage characteristic of sufficient magnitude to insure that charge carriers stored in FET accumulator 22 are drained and that photodiode 20 reaches a depleted state. A typical n-MOS accumulator, for example, can store a charge of from 10⁴ to 10⁶ electrons. This amount of charge can be drained to pixel ground 18 by a low-voltage reset pulse of duration one to ten µsec.

Convertor 30 is comprised of operational amplifier 32 and a resistive feedback element, such as feedback FET 52, placed between an output port 38 and negative input port 36 to form a closed-loop circuit. Bias voltage 62 is applied to power operational amplifier 32 at bias-voltage terminal 46, and low voltage 64 is applied to low-voltage terminal 48. Current signal 28 appearing at negative input port 36 of operational amplifier 32 is converted into voltage signal 50 at output port 38. The value of voltage signal 50, which is proportional to the amplitude of current signal 28 flowing to pixel 10, thus corresponds to the amount of optical radiation 12 acquired by pixel 10.

If desired, an external shutter (not shown) can be used to establish an image acquisition interval by determining the period of time during which optical radiation 12 radiates pixel 10. After pixel 10 has been initialized by reset pulse 24, the external shutter is opened to begin the acquisition interval. When the desired image signal has been acquired, the external shutter is closed. The flow of photo-generated charges to FET accumulator 22 is terminated and the acquisition interval ends. Alternatively, the acquisition interval for a pixel can be established without need for an external shutter as follows. With the application of reset pulse 24, pixel 10 is initialized and an acquisition interval is begun. The subsequent application of select pulse 26, which serves to detect the radiation received by photodiode 20, provides current signal 28 to convertor 30 and effectively terminates the acquisition interval.

### Operation of an Image Sensing Array

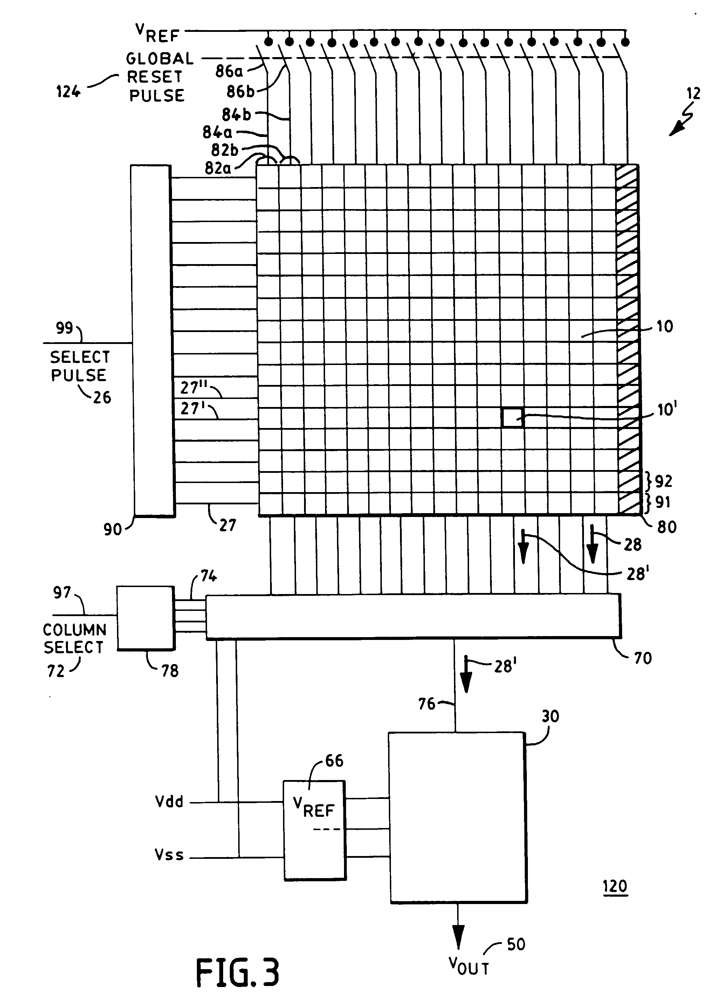

Fig. 3 shows an image sensing array 120, comprising: (i) a pixel array 80 for receiving incident radiation and outputting a current signal representative of the radiation being sensed corresponding to pixel location, (ii) a convertor 30 for converting pixel array current signals to voltage signals, (iii) a column multiplexer 70 for receiving the current signal outputs of all columns in pixel array 80 and transmitting the current from any designated array column to the convertor 30, and (iv) a row scanner 90 for applying a select pulse 26, sequentially to one row at a time, to the rows of pixels in pixel array 80.

Pixel array 80 is shown as a 16 × 16 array of pixels 10 for purpose of illustration and other array configurations, such as a 512 × 512 pixel array, can be used as well in accordance with features of the present invention. As described above, current signal 28 is produced when optical radiation strikes any pixel 10. In general, this signal varies from pixel to pixel and is proportional to that portion of a sensed image, represented by optical radiation 12, received by the particular pixel. As is understood by those skilled in the art, the electrical signal of each such pixel needs to be read out individually if the sensed image is to be retrieved and reconstructed from the signal stream of the pixel imaging array.

Image sensing array 120 provides a method by which the electrical signal of each pixel in pixel array 80 can be accessed and read out individually. A current signal 28', produced by a pixel 10' in pixel array 80, is obtained by the following method. Row scanner 90 serves to provide an electrical path between a scanner input line 99 and any one of the row output lines 27 between row scanner 90 and pixel array 80. In the example provided, row output line 27' has been designated because it runs to the row in which pixel 10' is located. A select pulse 26 is then applied to row output line 27' by way of scanner input line 99 and row scanner 90. This action closes the select switch of each pixel 10 in the designated row, including pixel 10', and completes an electrical path between column multiplexer 70 and source terminal of each pixel FET accumulator in the row selected by scanner 90.

The function of column multiplexer 70 is to complete an electrical path between convertor 30 and the column in which a designated pixel, such as pixel 10', is located. This action by column multiplexer 70, coupled with the closing of the select switch in pixel 10', causes reference voltage 66 to be applied to the source terminal of the accumulator of pixel 10', in the manner as was described above for the image sensing device 100 of Fig. 1. When reference voltage 66 is thus applied to pixel 10', current signal 28' appears on multiplexer output line 76 between column multiplexer 70 and convertor 30. The conversion of current signal 28' into voltage signal 50 is performed before the current signal from the next pixel is received by convertor 30. This process is continued until the current signal for each pixel in the selected row has been accessed and read out.

Subsequently, a successive select pulse 26 is transmitted along scanner input line 99, through row scanner 90, and to another output, such as row output line 27". Each pixel in the newly-selected row is accessed and a current signal is read out in the same manner as was done for the previous row. Each pixel row is thus accessed, in any convenient sequence, until all the pixels in pixel array 80 have been read out. For example, first row 91 can be read out before second row 92.

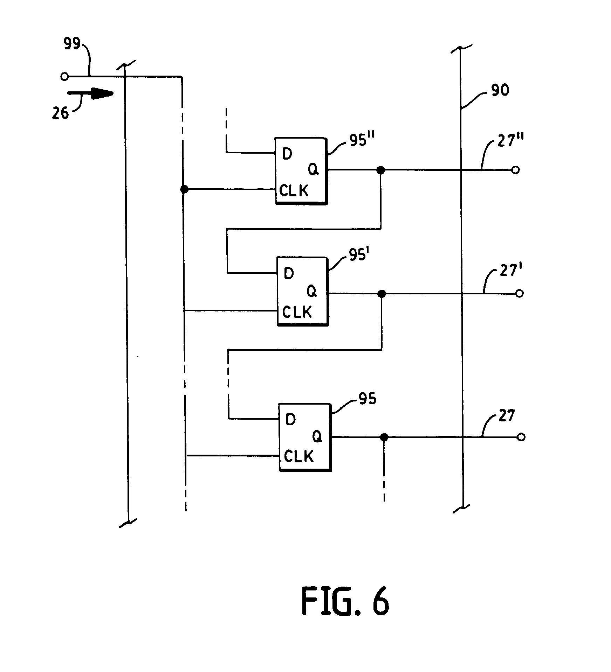

In a preferred embodiment, row scanner 90 includes a D flip-flop for each row contained in pixel array 80. The D flip-flops are implemented in accordance with standard digital methods using transmission gates and invertors. For example, each row flip-flop can include a first input line running from the output of a D flip-flop in another row *(e.g.,* the previous row). A second input line can serve as a clock input, with the select pulse 26 serving as the clock pulse. This configuration provides for a method of addressing each row of pixel array 80 in turn and requires only the single scanner input line 99 and select pulse 26 for operation. One embodiment of row scanner 90 is provided in Fig. 6. Pulse 26 is provided to the 'Clk' ports of a plurality of D flip-flops, such as D flip-flops 95, 95', and 95 ", by means of scanner input line 99. The 'D' port of each flip-flip is connected to the output 'Q' port of the flip-flop corresponding to the preceding row. Thus, when flip-flop 95" sends a signal pulse along row output line 27", flip-flop 95' is also thereby set. When a subsequent pulse 26 is input on scanner input line 99, flip-flop 95' will, in turn, send a signal pulse along row output line 27' and set the flip-flop corresponding to the next row in sequence.

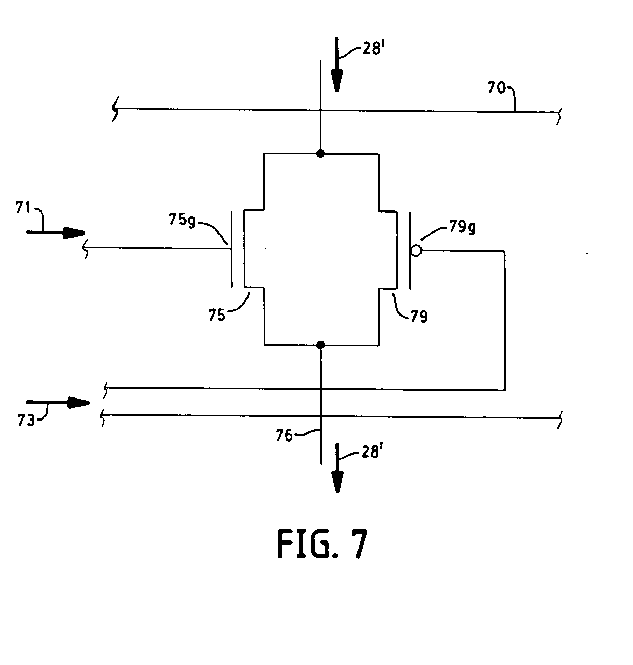

Using methods well-known in the art, column multiplexer 70 may be comprised of a series of transmission gates with one pair of transmission gates for each array column to which the column multiplexer is connected. The operation of the transmission gates themselves may be controlled by a column digital signal decoder 78. Column signal decoder 78 may receive column select pulses 72 on decoder input line 97 and sends out column control signals on column-select control lines 74. This operation is more clearly illustrated in Fig. 7, in which a column control signal 71 is applied to the gate 75g of a transmission gate n-MOSFET 75, and a column control complement signal 73 is applied to the gate 79g of a transmission gate p-MOSFET 79. Incoming current signal 28' is applied to one of the commonly-connected ends of MOSFETs 75 and 79. When column control signal 71 comprises a logic '1,' both n-MOSFET 75 and p-MOSFET 79 switch to an "on" state and transmit current signal 28' to multiplexer output line 76. When column control signal 71 changes state to a logic '0,' both n-MOSFET 75 and p-MOSFET 79 switch to an "off' state and do not transmit incoming current signal 28'. Each column of pixel array 80 in Fig. 3 is thus separately addressable, and addressable in any sequence.

In a typical imaging operation, the whole of pixel array 80 is irradiated whether imaging is being performed for still images or for video recording. The operation begins with an application of a reset pulse to each pixel in pixel array 80. In the embodiment shown, the reset-pulse line of each pixel in a first pixel column 82a is connected to a first reset line 84a. The resetting of the pixels in the first pixel column 82a is accomplished by temporarily closing a first column reset switch 86a, which causes the reset switch in each pixel of first pixel column 82a to close. This action applies reference voltage 66 to the photodiode terminal of each pixel in first pixel column 82a and initializes the corresponding pixel as described above in conjunction with Fig. 1. A second pixel column 82b is reset when a second column reset switch 86b is closed to apply reference voltage 66 to each pixel in second pixel column 82b by way of second reset line 84b. The remaining pixel columns in pixel array 80 are reset in a similar manner. Alternatively, resetting can be done in groups of columns rather than singly. In a preferred embodiment, each column reset switch is ganged with the other column reset switches to produce a global reset capability, by which all array columns are reset upon application of a global reset pulse 124.

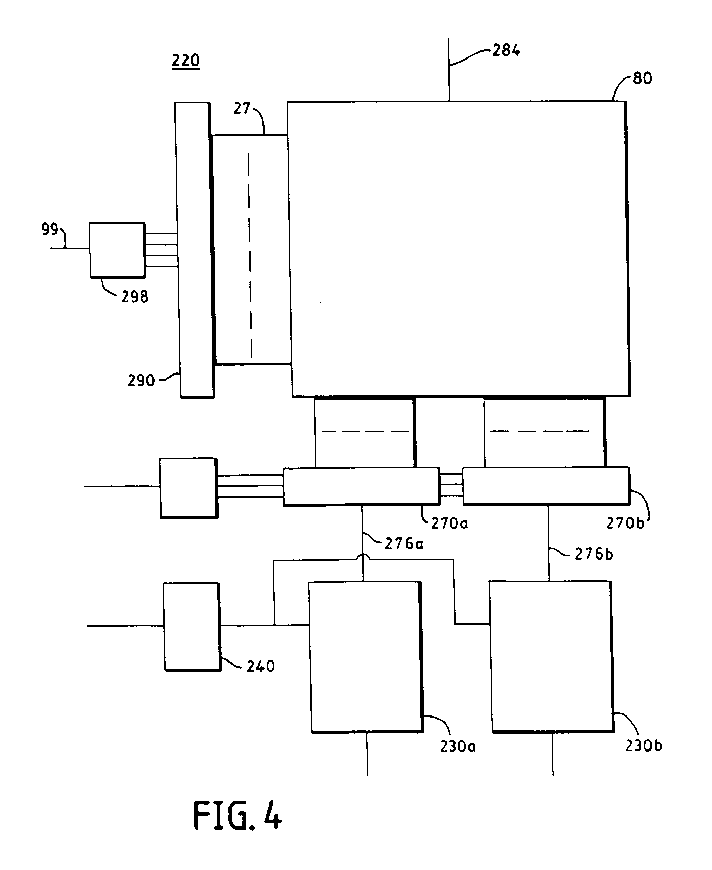

One alternative embodiment, shown in Fig. 4, provides for a parallel processing capability. Image sensing array 220 includes two convertors 230a and 230b, each used for converting the current signal on multiplexer output line 276a, from column multiplexer 270a, and on multiplexer output line 276b, from multiplexer 270b. With this configuration, the rate of signal output is approximately doubled from the signal output rate of the configuration, such as that shown in Fig. 1, in which only one convertor 30 is used. Note that only one bias source 240 is required to supply power to both convertors 230a and 230b.

This embodiment also includes a row digital signal decoder 298 and a row multiplexer 290 for row selection, instead of a scanner such as the scanner 90 of Fig. 3. This feature allows the accessing of pixel rows in sequence, or in another order as desired. A configuration having multiplexers for both pixel rows and pixel columns is useful in applications such as image processing where access to selected pixels, or groups of pixels, in pixel array 80 is necessary. Image sensing array 220 also includes a global reset line 284 by which a global reset pulse may be inputted.

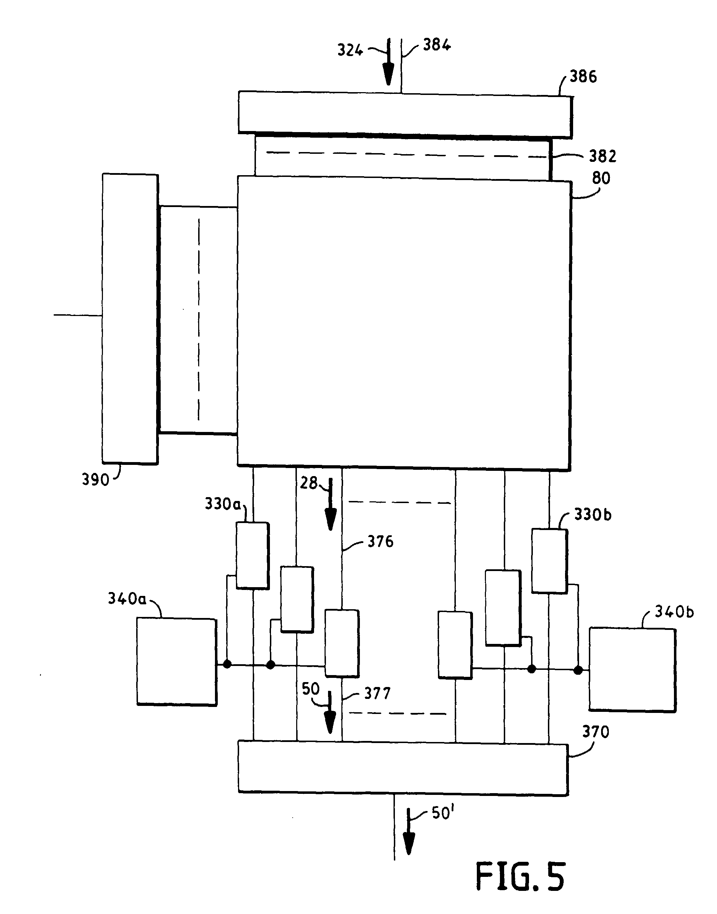

Alternatively, the column multiplexers 270a and 270b can be replaced by one or more column scanners by which pixel array columns could be accessed in a manner similar to the accessing of rows with the row scanner 90 of Fig. 3. Fig. 5 shows such a configuration, having a series of convertors 330a through 330b, one for the output of each column in an image sensing array 320. Although convertors 330a through 330b are shown as being powered by two bias sources 340a and 340b, the number of bias sources used can be larger as design considerations require.

In this embodiment, current signals are converted into voltage signals before passing through an outputting device such as a sequencer or a multiplexer. Current signal 28 flows along a column output line 376 to be converted into a voltage signal 50 on convertor output line 377. Voltage signal 50 is available as one of many voltage signal inputs to a column scanner 370. Column scanner 370 performs the function of selecting one input voltage signal at a time to output as voltage signal 50'.

A reset line 384 is provided to receive a reset pulse 324. Reset pulse 324 passes into a reset pulse distributor 386 which can be a sequencer or a multiplexer. Reset pulse distributor 386 transmits the incoming reset pulse 324 to one or more pixel array columns by way of one or more column input lines 382.

Those skilled in the art may make other changes to the described embodiments in accordance with the teachings of the invention. Therefore, the embodiments described should not be interpreted in a limiting sense.

## Claims

1. An image sensing device (100) for converting incident optical radiation (12) into an electrical signal output corresponding to the amount of radiation acquired, said device comprising:
a photosensitive element (20) for receiving the optical radiation (12) and generating charge carriers in proportion to the quantity of radiation acquired;
charge accumulation means (22g), for collecting the charge carriers generated by said photosensitive element (20) whereby an electrical field is produced, the magnitude of the electrical field so produced being proportional to the quantity of charge carriers collected; and
variable resistance means (22) having a first end connected to a device ground (18), said variable resistance means (22) responsive to said charge accumulation means (22g), wherein the resistance of said variable resistance means (22) is correlated to the magnitude of the electrical field produced by said charge accumulation means;
characterised in that said image sensing device (100) further comprises a constant potential reference voltage source (66) selectively connected to a second end (22s) of said variable resistance means (22) via an operational amplifier for maintaining said second end (22s) at an essentially constant potential, whereby a current signal output (28) is produced.

2. The image sensing device (100) of claim 1 further comprising current-to-voltage conversion means (30) for receiving said current signal output (28) and for producing a voltage signal output (50) having a value corresponding to the amplitude of said current signal output (28).

3. The image sensing device of claim 1 further comprising reset means (14) for placing said photosensitive element (20) into a depleted state whereby collected charge is removed from said charge accumulation means (22g).

4. The image sensing device of claim 1 wherein said photosensitive element (20) comprises a photodiode.

5. The image sensing device of claim 1 wherein said variable resistance means (22) comprises the channel of a field-effect transistor.

6. The image sensing device of claim 5 wherein said charge accumulation means (22g) comprises a field-effect transistor.

7. The image sensing device of claim 5 wherein said charge accumulation means comprises a dielectric capacitor (23).

8. The image sensing device of claim 5 wherein said charge accumulation means comprises a diffusion capacitance (23).

9. The image sensing device of claim 2 wherein said current-to-voltage conversion means (30) comprises an operational amplifier (32) and a resistive feedback element (52).

10. The image sensing device of claim 3 wherein said reset means (14) comprises an electrical reset switch, said electrical reset switch situated between said photosensitive element (20) and said reference voltage source (66), whereby closing of said electrical reset switch completes an electrical circuit between said reference voltage source (66) and said photosensitive element (20).

11. An image sensing array (120) for receiving optical radiation (12) from an image and producing an electrical signal output, said image sensing array (120) comprising:
a plurality of pixels (10), arranged in rows and columns, for receiving the optical radiation (12), each said pixel (10) comprising: a) a photosensitive element (20) for receiving the optical radiation (12) and generating charge carriers in proportion to the quantity of radiation acquired, b) charge accumulation means (22g) for collecting said charge carriers generated by said photosensitive element (20) whereby an electrical field is produced, the magnitude of said electrical field so produced being proportional to the quantity of charge carriers collected, c) variable resistance means (22) having a first end connected to a device ground (18), said variable resistance means (22) responsive to said charge accumulation means (22g), such that the resistance of said variable resistance means (22) is correlated to the magnitude of said electrical field produced by said charge accumulation means (22g), and d) a pixel select switch (16) connected to said charge accumulation means (22g);
row select means (90) for closing pixel select switches (16) of at least one selected row (91) of said pixels; and
column select means (70) for receiving the electrical signals (28) produced by said pixels (10) and for outputting the electrical signal (28) produced in at least one selected column (82a) of said pixels.
characterised in that said image sensing array (120) further comprises at least one constant potential reference voltage source (66), whereby closing said pixel select switch (16) acts to selectively connect said constant potential reference voltage source (66) to a second end (22s) of a corresponding one of said variable resistance means (22) via an operational amplifier to produce said electrical signal (28), the amplitude of said electrical signal (28) being proportional to the electrical resistance of a corresponding one of said variable resistance means (22).

12. The image sensing array of claim 11 further comprising at least one current-to-voltage conversion means (30) for receiving the electrical signal (28) produced in at least one of said pixels (10) upon closing of a corresponding said pixel select switch (16) and for producing a voltage signal (50) having a value corresponding to the amplitude of the electrical signal (28).

13. The image sensing array of claim 11 further comprising reset means (14) for placing said photosensitive elements (20) into depleted states.

14. The image sensing array of claim 11 wherein said photosensitive element (20) comprises a photodiode.

15. The image sensing array of claim 11 wherein said variable resistance means (22) comprises the channel of a field-effect transistor.

16. The image sensing array of claim 15 wherein said charge accumulation means (22g) comprises a field-effect transistor.

17. The image sensing array of claim 15 wherein said charge accumulation means comprises a dielectric capacitor (23).

18. The image sensing array of claim 15 wherein said charge accumulation means comprises a diffusion capacitance (23).

19. The image sensing array of claim 12 wherein said current-to-voltage conversion means (30) comprises an operational amplifier (32) and a resistive feedback element (52).

20. The image sensing array of claim 13 wherein said reset means (16) comprises at least one electrical reset switch, said electrical reset switch situated between one said photosensitive element (20) and one said reference voltage source (66), whereby closing of said electrical reset switch completes an electrical circuit between said reference voltage source (66) and said photosensitive element (20).

21. The image sensing array of claim 11 wherein said row select means (90) comprises a flip-flop (95) for each row )91) of said pixels (10) in said image sensing array (120).

22. The image sensing array of claim 11 wherein said column select means (70) comprises a pair of transmission gates (75, 79) for each column (82) of said pixels (10) in said image sensing array (120).

23. A method for converting optical radiation into an electrical signal corresponding to the amount of radiation (12) received, said method comprising the steps of:
generating charge carriers in proportion to the amount of optical radiation received;
collecting the charge carriers generated;
producing an electrical field, the magnitude of the electrical field so produced being proportional to the quantity of charge carriers collected;
providing an electrical resistance (22) proportional to the magnitude of the electrical field produced; and
connecting a first end of said electrical resistance to a device ground potential (18); characterised in that said method further comprises the step of selectively connecting a second end (22s) of said electrical resistance (22) via an operational amplifier to a constant potential reference voltage source (66) such that an electrical signal (28) is produced, the magnitude of the electrical signal (28) being proportional to the value of said electrical resistance (22).

24. The method of claim 23 further comprising the step of converting said electrical signal (28) into a voltage signal (50) having a voltage level proportional to the magnitude of said electrical signal (28).

25. The method of claim 23 further comprising the step of clearing collected charge carriers subsequent to said step of producing said electrical signal (28).

## Patentansprüche

1. Bildsensor (100) zur Umwandlung einfallender optischer Strahlung (12) in einen elektrischen Signalausgang, dessen Größe der aufgefangenen Strahlung entspricht, mit den folgenden Merkmalen:
ein lichtempfindliches Element (20) zum Empfang der optischen Strahlung (12) und zur Erzeugung von Ladungsträgern proportional zur Menge der aufgefangenen Strahlung;
ein Ladungsakkumulator (22g) zum Sammeln der Ladungsträger, die durch das lichtempfindliche Element (20) erzeugt wurden, wodurch ein elektrisches Feld erzeugt wird und die Größe des so erzeugten elektrischen Feldes proportional der Menge der gesammelten Ladungsträger ist; und
ein variabler Widerstand (22), dessen erstes Ende an Masse (18) gelegt ist und der auf den Ladungsakkumulator (22g) anspricht, wobei der Widerstand des variablen Widerstands (22) auf die Größe des elektrischen Feldes bezogen ist, das durch den Ladungsakkumulator erzeugt wurde;
dadurch gekennzeichnet, daß der Bildsensor (100) außerdem eine Bezugsspannungsquelle (66) mit konstantem Potential aufweist, die selektiv an ein zweites Ende (22s) des variablen Widerstandes (22) über einen optischen Verstärker verbunden ist, um das zweite Ende (22s) auf einem 5 im wesentlichen konstanten Potential zu halten, wodurch ein Stromausgangssignal (28) erzeugt wird.

2. Bildsensor (100) nach Anspruch 1, welcher außerdem einen Strom-Spannungswandler (30) aufweist, um das Stromausgangssignal (28) zu empfangen und um ein Ausgangs-Spannungssignal (50) zu erzeugen, dessen Wert der Amplitude des Stromausgangssignals (28) entspricht.

3. Bildsensor nach Anspruch 1, welcher außerdem Rückstellmittel (14) aufweist, um das lichtempfindliche Element (20) in einen Verarmungszustand zu überführen, wodurch die gesammelte Ladung vom Ladungsakkumulator (22g) entfernt wird.

4. Bildsensor nach Anspruch 1, bei welchem das lichtempfindliche Element (20) eine Photodiode ist.

5. Bildsensor nach Anspruch 1, bei welchem der variable Widerstand (22) der Kanal eines Feldeffekttransistors ist.

6. Bildsensor nach Anspruch 5, bei welchem der Ladungsakkumulator (22g) einen Feldeffekttransistor aufweist.

7. Bildsensor nach Anspruch 5, bei welchem der Ladungsakkumulator einen dielektrischen Kondensator (23) aufweist.

8. Bildsensor nach Anspruch 5, bei welchem der Ladungsakkumulator einen Diffusionskondensator (23) aufweist.

9. Bildsensor nach Anspruch 2, bei welchem der Strom-Spannungswandler (30) aus einem Operationsverstärker (32) mit Widerstands-Rückkopplungselement (52) besteht.

10. Bildsensor nach Anspruch 3, bei welchem die Rückstellmittel (14) einen elektrischen Rücksetzschalter aufweisen und der elektrische Rücksetzschalter zwischen dem lichtempfindlichen Element und der Bezugsspannungsquelle (66) angeordnet ist, wodurch beim Schließen des elektrischen Rücksetzschalters ein elektrischer Kreis zwischen der Bezugsspannungsquelle (66) und dem lichtempfindlichen Element (20) geschlossen wird.

11. Bildsensormatrix (120) zum Empfang optischer Strahlung (12) von einem Bild und zur Erzeugung eines elektrischen Signalausgangs, wobei die Bildsensormatrix (120) folgende Merkmale aufweist:
eine Vielzahl von Pixeln (10), die in Reihen und Spalten angeordnet sind, um die optische Strahlung (12) zu empfangen, wobei jedes Pixel (10) folgende Merkmale aufweist: a) ein lichtempfindliches Element (20) zum Empfang der optischen Strahlung (12) und zur Erzeugung von Ladungsträgern proportional zur Menge der aufgefangenen Strahlung, b) einen Ladungsakkumulator (22g) zum Sammeln der Ladungsträger, die durch das lichtempfindliche Element (20) erzeugt wurden, wodurch ein elektrisches Feld erzeugt wird und die Größe des so erzeugten elektrischen Feldes proportional zur Menge der gesammelten Ladungsträger ist, c) einen variablen Widerstand (22), der mit einem ersten Ende an Masse (18) gelegt ist und auf den Ladungsakkumulator (22g) derart anspricht, daß der Widerstandswert des variablen Widerstandes (22) auf die Größe des vom Ladungsakkumulator (22g) erzeugten elektrischen Feldes bezogen ist und d) einen Pixelwählschalter (16), der mit dem Ladungsakkumulator (22g) verbunden ist;
Reihen-Wähleinrichtungen (90) zum Schließen der Pixelwählschalter (18) wenigstens einer gewählten Reihe (91) von Pixeln, und
Spalten-Wählvorrichtungen (70) zum Empfang der elektrischen Signale (28), die durch die Pixel (10) erzeugt wurden und zur Ausgabe des elektrischen Signals (28), das in wenigstens einer gewählten Spalte (82a) der Pixel erzeugt wurde,
dadurch gekennzeichnet, daß die Bildsensormatrix (120) außerdem wenigstens eine Bezugsspannungsquelle (66) mit konstantem Potential aufweist, wodurch das Schließen des Pixelwählschalters (16) bewirkt, daß selektiv die Bezugsspannungsquelle (66) konstanten Potentials an ein zweites Ende (22s) eines entsprechenden variablen Widerstandes (22) über einen Operationsverstärker angeschlossen wird, um das elektrische Signal (28) zu erzeugen, wobei die Amplitude des elektrischen Signals (28) proportional zu dem elektrischen Widerstand des jeweiligen variablen Widerstands (22) ist.

12. Bildsensormatrix nach Anspruch 11, welche außerdem wenigstens einen Strom-Spannungswandler (30) aufweist, um das elektrische Signal (28) zu empfangen, das in wenigstens einem der Pixel (10) nach Schließen eines entsprechenden Pixelwählschalters (16) erzeugt wurde und zur Erzeugung eines Spannungssignals (50) mit einem Wert, der der Amplitude des elektrischen Signals (28) entspricht.

13. Bildsensormatrix nach Anspruch 11, welche außerdem Rücksetzmittel (14) aufweist, um die lichtempfindlichen Elemente (20) in einen Verarmungszustand zu setzen.

14. Bildsensormatrix nach Anspruch 11, bei welcher das lichtempfindliche Element (20) eine Photodiode ist.

15. Bildsensormatrix nach Anspruch 11, bei welcher der variable Widerstand (22) einen Kanal eines Feldeffekttransistors aufweist.

16. Bildsensormatrix nach Anspruch 15, bei welcher der Ladungsakkumulator (22g) einen Feldeffekttransistor aufweist.

17. Bildsensormatrix nach Anspruch 15, bei welcher der Ladungsakkumulator einen dielektrischen Kondensator (23) aufweist.

18. Bildsensormatrix nach Anspruch 15, bei welcher der Ladungsakkumulator einen Diffusionskondensator (23) aufweist.

19. Bildsensormatrix nach Anspruch 12, bei welcher der Strom-Spannungswandler (30) einen Operationsverstärker (32) mit einem Widerstands-Rückkopplungselement (52) aufweist.

20. Bildsensormatrix nach Anspruch 13, bei welcher die Rücksetzmittel (16) wenigstens einen elektrischen Rücksetzschalter aufweisen und der elektrische Rücksetzschalter zwischen das lichtempfindliche Element (20) und die eine Bezugsspannungsquelle (66) geschaltet ist, wodurch beim Schließen des elektrischen Rücksetzschalters ein elektrischer Kreis zwischen der Bezugsspannungsquelle (66) und dem lichtempfindlichen Element (20) geschlossen wird.

21. Bildsensormatrix nach Anspruch 11, bei welcher die Reihen-Wählvorrichtung (90) ein Flip-Flop (95) für jede Reihe (91) der Pixel (10) in der Bildsensormatrix (120) aufweist.

22. Bildsensormatrix nach Anspruch 11, bei welcher die Spalten-Wählvorrichtung (70) ein Paar von Transmissionsgattern (75, 79) für jede Spalte (82) der Pixel (10) in der Bildsensormatrix (120) aufweist.

23. Verfahren zur Umwandlung optischer Strahlung in ein elektrisches Signal, das der empfangenen Strahlungsmenge (12) entspricht, wobei das Verfahren die folgenden Schritte aufweist:
es werden Ladungsträger proportional zur Menge der empfangenen optischen Strahlung erzeugt;
es werden die erzeugten Ladungsträger gesammelt;
es wird ein elektrisches Feld erzeugt, wobei die Größe des so erzeugten elektrischen Feldes proportional zur Menge der gesammelten Ladungsträger ist;
es wird ein elektrischer Widerstand (22) proportional zur Größe des elektrischen Feldes erzeugt; und
es wird ein erstes Ende des elektrischen Widerstandes mit Masse (18) verbunden,
dadurch gekennzeichnet, daß das Verfahren außerdem den Schritt aufweist, selektiv ein zweites Ende (22s) des elektrischen Widerstandes (22) über einen Operationsverstärker mit einer Bezugsspannungsquelle (66) konstanten Potentials derart zu verbinden, daß ein elektrisches Signal (28) erzeugt wird, wobei die Größe des elektrischen Signals (28) proportinal zu dem Wert des elektrischen Widerstandes (22) ist.

24. Verfahren nach Anspruch 23, welches weiterhin den Schritt aufweist, das elektrische Signal (28) in ein Spannungssignal (50) umzuwandeln, dessen Spannungspegel proportinal zur Größe des elektrischen Signals (28) ist.

25. Verfahren nach Anspruch 23, welches außerdem den Schritt aufweist, die gesammelten Ladungsträger zu löschen nachdem das elektrische Signal (28) erzeugt ist.

## Revendications

1. Dispositif (100) capteur d'images pour convertir un rayonnement optique (12) incident en un signal électrique de sortie correspondant à la quantité de rayonnement reçue, ledit dispositif comprenant :
un élément photosensible (20) destiné à recevoir le rayonnement optique (12) et à générer des porteurs de charges proportionnellement à la quantité de rayonnement reçue;
un moyen d'accumulation (22g) de charges, destiné à capter les porteurs de charges générés par ledit élément photosensible (20) par lequel un champ électrique est produit, l'amplitude du champ électrique ainsi produit étant proportionnelle à la quantité de porteurs de charges captés; et
un moyen (22) formant résistance variable comportant une première extrémité reliée à une masse (18), ledit moyen (22) formant résistance variable étant sensible audit moyen d'accumulation (22g) de charges, dans lequel la résistance dudit moyen (22) formant résistance variable est liée à l'amplitude du champ électrique produit par ledit moyen d'accumulation de charges;
caractérisé en ce que ledit dispositif (100) capteur d'images comprend de plus une source (66) de tension de référence constante reliée sélectivement à une seconde extrémité (22s) dudit moyen (22) formant résistance variable via un amplificateur opérationnel afin de maintenir ladite seconde extrémité (22s) à un potentiel globalement constant, par lequel un signal de sortie (28) en courant est produit.

2. Dispositif (100) capteur d'images selon la revendication 1, comprenant de plus un moyen (30) de conversion courant-tension destiné à recevoir ledit signal de sortie (28) en courant et à produire un signal de sortie (50) en tension ayant une valeur correspondant à l'amplitude dudit signal de sortie (28) en courant.

3. Dispositif capteur d'images selon la revendication 1, comprenant de plus un moyen (14) de mise à zéro destiné à mettre ledit élément photosensible (20) dans un état déchargé par lequel la charge accumulée est retirée dudit moyen d'accumulation (22g) de charges.

4. Dispositif capteur d'images selon la revendication 1, dans lequel ledit élément photosensible (20) comprend une photodiode.

5. Dispositif capteur d'images selon la revendication 1, dans lequel ledit moyen (22) formant résistance variable comprend le canal d'un transistor à effet de champ.

6. Dispositif capteur d'images selon la revendication 5, dans lequel ledit moyen d'accumulation (22g) de charges comprend un transistor à effet de champ.

7. Dispositif capteur d'images selon la revendication 5, dans lequel ledit moyen d'accumulation de charges comprend un condensateur diélectrique (23).

8. Dispositif capteur d'images selon la revendication 5, dans lequel ledit moyen d'accumulation de charges comprend une capacité de diffusion (23).

9. Dispositif capteur d'images selon la revendication 2, dans lequel ledit moyen (30) de conversion courant-tension comprend un amplificateur opérationnel (32) et un élément (52) de contre-réaction résistif.

10. Dispositif capteur d'images selon la revendication 3, dans lequel ledit moyen (14) de mise à zéro comprend un interrupteur de mise à zéro électrique, ledit interrupteur de mise à zéro électrique étant situé entre ledit élément photosensible (20) et ladite source (66) de tension de référence, la fermeture dudit interrupteur de mise à zéro électrique complétant un circuit électrique entre ladite source (66) de tension de référence et ledit élément photosensible (20).

11. Réseau (120) capteur d'images destiné à recevoir le rayonnement optique (12) provenant d'une image et à produire un signal électrique de sortie, ledit réseau (120) capteur d'images comprenant :
une pluralité de pixels (10) disposés en rangées et en colonnes, et servant à recevoir le rayonnement optique (12), chacun desdits pixels (10) comprenant : a) un élément photosensible (20) destiné à recevoir le rayonnement optique (12) et à générer des porteurs de charges proportionnellement à la quantité de rayonnement reçue, b) un moyen d'accumulation (22g) de charges, destiné à capter lesdits porteurs de charges générés par ledit élément photosensible (20) par lequel un champ électrique est produit, l'amplitude dudit champ électrique ainsi produit étant proportionnelle à la quantité de porteurs de charges captés, c) un moyen (22) formant résistance variable comportant une première extrémité reliée à une masse (18), ledit moyen (22) formant résistance variable étant sensible audit moyen d'accumulation (22g) de charges, de sorte que la résistance dudit moyen (22) formant résistance variable est liée à l'amplitude dudit champ électrique produit par ledit moyen d'accumulation (22g) de charges, et d) un interrupteur (16) de sélection de pixel relié audit moyen d'accumulation (22g) de charges;
un moyen (90) de sélection de rangée servant à fermer les interrupteurs (16) de sélection de pixel d'au moins une rangée (91) sélectionnée desdits pixels; et
un moyen (70) de sélection de colonne servant à recevoir les signaux électriques (28) produits par lesdits pixels (10) et à faire sortir le signal électrique (28) produit dans au moins une colonne (82a) sélectionnée desdits pixels;
caractérisé en ce que ledit réseau (120) capteur d'images comprend de plus au moins une source (66) de tension de référence constante, la fermeture dudit interrupteur (16) de sélection de pixel servant à connecter sélectivement ladite source (66) de tension de référence constante à une seconde extrémité (22s) d'un moyen correspondant desdits moyens (22) formant résistance variable via un amplificateur opérationnel afin de produire ledit signal électrique (28), l'amplitude dudit signal électrique (28) étant proportionnelle à la résistance électrique d'un moyen correspondant desdits moyens (22) formant résistance variable.

12. Réseau capteur d'images selon la revendication 11 comprenant de plus au moins un moyen (30) de conversion courant-tension destiné à recevoir le signal électrique (28) produit dans au moins un desdits pixels (10) par la fermeture d'un desdits interrupteurs (16) de sélection de pixel correspondant et à produire un signal (50) en tension ayant une valeur correspondant à l'amplitude du signal électrique (28).

13. Réseau capteur d'images selon la revendication 11 comprenant de plus un moyen (14) de mise à zéro destiné à mettre lesdits éléments photosensibles (20) dans des états déchargés.

14. Réseau capteur d'images selon la revendication 11 dans lequel ledit élément photosensible (20) comprend une photodiode.

15. Réseau capteur d'images selon la revendication 11, dans lequel ledit moyen (22) formant résistance variable comprend le canal d'un transistor à effet de champ.

16. Réseau capteur d'images selon la revendication 15, dans lequel ledit moyen d'accumulation (22g) de charges comprend un transistor à effet de champ.

17. Réseau capteur d'images selon la revendication 15, dans lequel ledit moyen d'accumulation de charges comprend un condensateur diélectrique (23).

18. Réseau capteur d'images selon la revendication 15, dans lequel ledit moyen d'accumulation de charges comprend une capacité de diffusion (23).

19. Réseau capteur d'images selon la revendication 12, dans lequel ledit moyen (30) de conversion courant-tension comprend un amplificateur opérationnel (32) et un élément (52) de contre-réaction résistif.

20. Réseau capteur d'images selon la revendication 13, dans lequel ledit moyen (14) de mise à zéro comprend au moins un interrupteur de mise à zéro électrique, ledit interrupteur de mise à zéro électrique étant situé entre un desdits éléments photosensibles (20) et une desdites sources (66) de tension de référence, la fermeture dudit interrupteur de mise à zéro électrique complétant un circuit électrique entre ladite source (66) de tension de référence et ledit élément photosensible (20).

21. Réseau capteur d'images selon la revendication 11, dans lequel ledit moyen (90) de sélection de rangée comprend une bascule (95) pour chaque rangée (91) desdits pixels (10) dudit réseau (120) capteur d'images.

22. Réseau capteur d'images selon la revendication 11, dans lequel ledit moyen (70) de sélection de colonne comprend une paire de portes (75, 79) de transmission pour chaque colonne (82) desdits pixels (10) dudit réseau (120) capteur d'images.

23. Procédé de conversion de rayonnement optique en un signal électrique correspondant à la quantité de rayonnement (12) reçue, ledit procédé comprenant les étapes consistant à :
générer des porteurs de charges proportionnellement à la quantité de rayonnement optique reçue;
capter les porteurs de charges générés;
produire un champ électrique, l'amplitude du champ électrique ainsi produit étant proportionnelle à la quantité de porteurs de charges captés;
prévoir une résistance électrique (22) proportionnelle à l'amplitude du champ électrique produit; et
connecter une première extrémité de ladite résistance électrique à un potentiel de masse (18); caractérisé en ce que ledit procédé comprend de plus l'étape consistant à connecter sélectivement une seconde extrémité (22s) de ladite résistance électrique (22) à une source (66) de tension de référence constante via un amplificateur opérationnel afin de produire un signal électrique (28), l'amplitude de ce signal électrique (28) étant proportionnelle à la valeur de ladite résistance électrique (22).

24. Procédé selon la revendication 23, comprenant de plus l'étape consistant à convertir ledit signal électrique (28) en un signal (50) en tension présentant un niveau de tension proportionnel à l'amplitude dudit signal électrique (28).

25. Procédé selon la revendication 23, comprenant de plus l'étape consistant à supprimer les porteurs de charges captés, consécutifs à ladite étape de production dudit signal électrique (28).
